## Europäisches Patentamt
## European Patent Office
## Office européen des brevets

(11) Numéro de publication: **0 064 450**
**B1**

(12) **FASCICULE DE BREVET EUROPEEN**

(45) Date de publication du fascicule du brevet:
21.11.84

(21) Numéro de dépôt: **82400732.2**

(22) Date de dépôt: **23.04.82**

(51) Int. Cl.³: **H 03 K 17/06**

(54) Procédé et dispositif autoadaptatif d'amorçage d'un triac.

(30) Priorité: **27.04.81 FR 8108336**

(43) Date de publication de la demande:
**10.11.82 Bulletin 82/45**

(45) Mention de la délivrance du brevet:
**21.11.84 Bulletin 84/47**

(84) Etats contractants désignés:
**DE FR GB IT NL**

(56) Documents cités:
**DE - A - 1 946 331**
**FR - A - 2 149 142**
**US - A - 3 728 557**

(73) Titulaire: **THOMSON-CSF, 173, Boulevard Haussmann, F-75379 Paris Cedex 08 (FR)**

(72) Inventeur: **Lamboley, Jean-Jacques, THOMSON-CSF SCPI 173, bld Haussmann, F-75379 Paris Cedex 08 (FR)**

(74) Mandataire: **de Beaumont, Michel et al, THOMSON-CSF SCPI 173, Bld Haussmann, F-75379 Paris Cedex 08 (FR)**

BUNDESDRUCKEREI BERLIN

## Description

La présente invention concerne un procédé et un dispositif autoadaptif d'amorçage d'un triac à angle de conduction réglable.

Un triac est un dispositif à conduction bi-directionnelle qui devient conducteur quand un courant d'intensité suffisante est injecté dans sa gâchette et qui reste ensuite conducteur indépendamment du courant de gâchette dès que, et tant que, il est traversé entre ses électrodes principales par un courant d'intensité supérieure à un seuil donné.

Ainsi, dans les circuits de commande de triac, éventuellement réalisés sous forme de circuits intégrés, on cherche à fournir à la gâchette d'un triac une impulsion d'amplitude et de durée suffisante pour en permettre l'amorçage. Néanmoins, pour éviter d'augmenter la consommation du circuit de commande, on cherche à limiter au maximum cette amplitude et cette durée. La détermination de l'amplitude de l'impulsion à appliquer est relativement simple et dépend des caractéristiques du triac, notamment des quadrants dans lesquels la commande est effectuée, certains quadrants étant plus sensibles que d'autres. Le choix de la durée de l'impulsion de commande est beaucoup plus délicat car il dépend des caractéristiques du circuit de charge dans lequel est inséré le triac. En particulier, si ce circuit de charge présente une self relativement importante, la durée d'établissement du courant sera lente et il conviendra de choisir une impulsion de longueur importante, cette longueur étant fonction de la nature du circuit de charge.

On est donc amené, si l'on veut réaliser un circuit de commande de triac pouvant fonctionner avec des charges de natures différentes, à choisir des durées d'impulsions de commande de gâchette relativement importantes, la longueur de ces impulsions étant superfétatoire dans le cas où la charge est peu ou pas selfique. Il en résulte une consommation énergétique pour le circuit de commande de gâchette inutilement importante dans ce dernier cas.

Ainsi, un objet de la présente invention est de prévoir un procédé et un dispositif d'amorçage d'un triac permettant une faible dissipation d'énergie dans le circuit de commande.

Dans la présente invention, on s'intéressera plus particulièrement à la commande à angle de conduction réglable de la mise en conduction d'un triac alimenté par un courant périodique, par exemple à 50 Hz.

Il s'agit donc de fournir une première impulsion au triac après une durée déterminée en fonction de l'angle de conduction choisi, puis de répéter des impulsions successives si la première impulsion n'a pas suffi à produire l'amorçage. Une difficulté se présente, à savoir qu'à la fin de la période de conduction, le triac se désamorce. Il en résulte une remontée de la tension aux bornes de celui-ci et cette remontée ne doit pas être interprétée comme un défaut d'amorçage car ceci conduirait à fournir une ou plusieurs impulsions au début d'une alternance et donc à effectuer une commande »plein angle«.

Pour atteindre ses objets, la présente invention prévoit un procédé et un dispositif autoadaptatif d'amorçage d'un triac. Ce procédé qui comprend les étapes consistant à: fournir une première impulsion brève de gâchette au triac à l'instant choisi; détecter le non-amorçage éventuel du triac après l'arrêt de l'impulsion de gâchette; fournir une autre impulsion brève de gâchette au triac au cas où la détection a indiqué un non-amorçage; et répéter ces opérations jusqu'à amorçage est caractériste en ce que l'intervalle de temps maximal entre deux impulsions brèves de gâchette, c'est-à-dire la durée pendant laquelle est effectuée la détection d'un éventuel non-amorçage et la possibilité de fournir une autre impulsion brève de gâchette, est suffisamment court pour que le courant dans la charge ne subisse pas de décroissance notable pendant cet intervalle. La détection de l'amorçage est de préférence effectuée par détection de la tension aux bornes du triac en l'absence d'impulsion de gâchette.

Un dispositif autoadaptatif d'amorçage d'un triac en série avec une charge électronique comprend: un circuit pour détecter que la tension aux bornes du triac a dépassé un seuil déterminé, ce circuit fournissant un signal à haut niveau quand et tant que ce seuil est dépassé; un circuit modulateur réglable recevant le signal en provenance du détecteur et fournissant une première impulsion de commande de gâchette de durée brève au bout d'un temps réglé après que le signal du détecteur soit passé du niveau bas au niveau haut. Le dispositif d'amorgage selon l'invention est caractérisé en ce que le circuit modulateur ne peut fournir la première impulsion de gâchette que si le signal du détecteur reste à niveau haut pendant toute la durée du temps réglé. Ce dispositif comprend en outre des moyens pour fournir d'autres impulsions brèves de gâchette au triac si le signal du détecteur repasse du niveau bas au niveau haut au cours d'un intervalle de temps suivant l'application de chaque impulsion brève, cet intervalle de temps ayant une durée suffisamment courte pour que le courant dans la charge ne subisse pas de décroissance notable au cours de son écoulement.

Ainsi, selon la nature de la charge, on sera amené à fournir un plus ou moins grand nombre d'impulsions de gâchette pour commander le triac, ce nombre d'impulsions étant strictement limité au nombre nécessaire.

Ces objets, caractéristiques et avantages ainsi que d'autres de la présente invention seront exposé plus en détail dans la description suivante de modes de réalisation particuliers faite en relation avec les figures jointes parmi lesquelles:

les figures 1 et 3 représentent des modes de réalisation de la présente invention;

la figure 2 représente des schémas de tension permettant d'illustrer le fonctionnement du circuit de la figure 1.

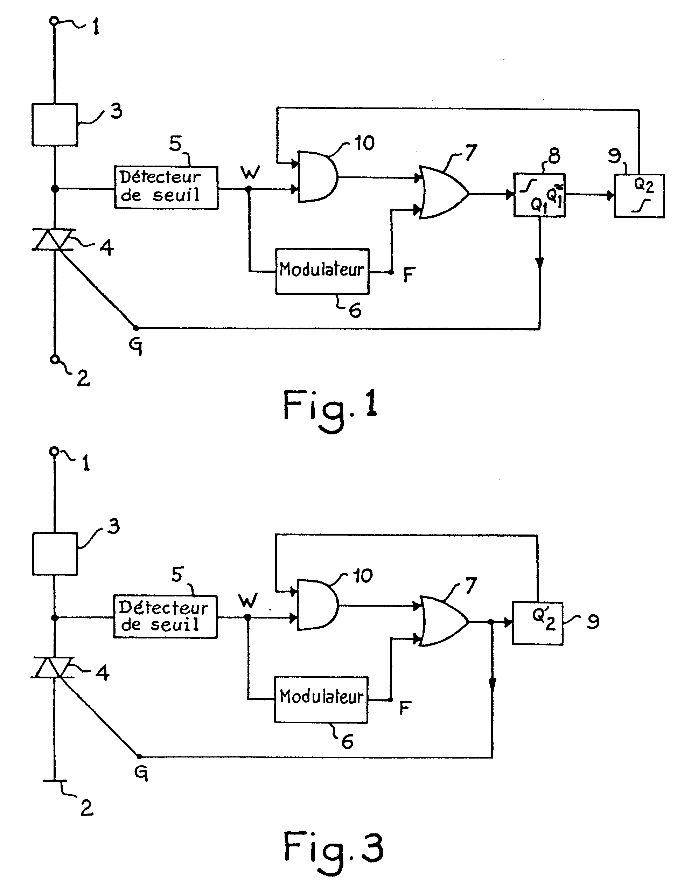

La figure 1 représente de façon schématique et sous forme de blocs un mode de réalisation de la présente invention. Une tension d'alimentation est appliquée entre les bornes 1 et 2 entre lesquelles sont disposés en série une charge 3 et un triac 4.

Aux bornes du triac 4 est disposé un détecteur de seuil 5. Ce détecteur de seuil est un circuit qui fournit une impulsion W à haut niveau quand la tension du triac est supérieure à un seuil déterminé et à bas niveau quand cette tension est inférieure au seuil. La sortie de détecteur de seuil 5 est transmise à un modulateur 6 fournissant un signal de sortie en impulsion F. Une impulsion F est fournie après un retard déterminé à la suite d'une transition de niveau bas à niveau haut du signal W à condition qu'il ne se soit pas produit à l'intérieur d'un intervalle de temps déterminé une transition de niveau haut à niveau bas de ce signal W. Le signal F est transmis par l'intermédiaire d'une porte OU 7 à une bascule monostable 8. La sortie Q1 de cette bascule monostable fournit un signal de durée constante réglée à la suite de la réception d'un front montant. Cette sortie Q1 est connectée à la borne G de gâchette du triac 4. La sortie complémentaire Q1* de la bascule 8 est connectée à une seconde bascule monostable 9, également déclenchable par des fronts de tension montants. La sortie Q2 de cette bascule monostable 9 est connectée à la deuxième entrée d'une porte ET 10 dont la première entrée reçoit le signal W de sortie du détecteur de seuil 5 et dont la sortie est connectée à une deuxième entrée de la porte OU 7.

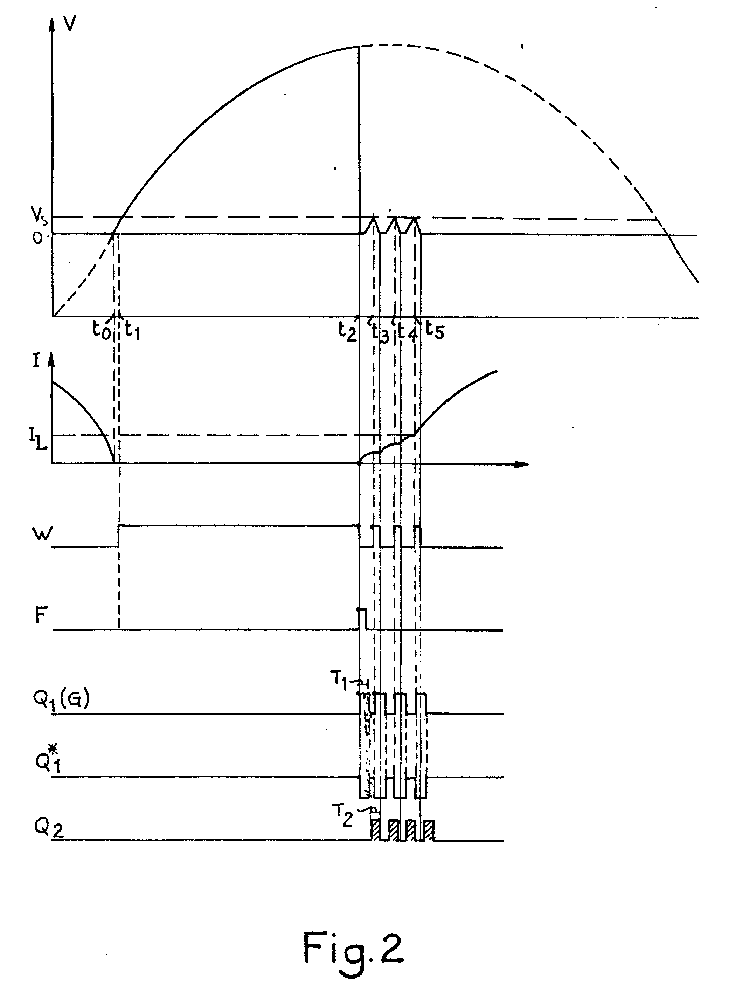

Le fonctionnement de ce circuit sera exposé maintenant en relation avec la figure 2 qui représente diverses formes d'ondes de tension et de courant en fonction du temps en divers points du circuit de la figure 1. Notamment, sont représentés la tension V aux bornes du triac, le courant I dans le circuit de charge, le signal W à la sortie du détecteur de seuil 5, le signal F à la sortie du modulateur 6, des signaux de sortie Q1 et Q1* de la bascule monostable 8 et le signal de sortie Q2 de la bascule monostable 9. Dans cette figure 2, on notera qu'aucune échelle n'est respectée en ce qui concerne, d'une part, les intensités des divers signaux, d'autre part, à l'intérieur d'une courbe donnée les largeurs relatives des divers signaux ou impulsions, la largeur des impulsions de déclenchement étant de l'ordre de la microseconde ou de la dizaine de microsecondes, alors que la largeur d'une alternance de la tension de secteur est de 10 millisecondes si cette tension se présente à une fréquence de 50 Hz.

On suppose que le triac est initialement dans un état conducteur. A l'instant t0, la tension du secteur s'annule et l'on passe d'une alternance positive à une alternance négative. Alors, en l'absence de signal de gâchette, le triac passe dans un état non conducteur dès que le courant dans la charge s'annule. A l'instant t1, la tension V aux bornes de ce triac atteint une valeur de seuil $V_S$ et le signal W passe d'un niveau bas à un niveau haut. La tension de seuil $V_S$ peut être choisie à une valeur de l'ordre de 10 volts. Il est important que cette valeur soit aussi faible que possible de façon compatible avec un bonne détection compte tenu de la tension résiduelle aux bornes du triac et des bruits électriques ambiants. Le modulateur 6 détecte cette montée du signal W et fournit à un instant t2, après un intervalle de temps préréglé qui dépend de l'angle de conduction choisi, une impulsion brève F. Le triac est alors mis en conduction et le signal W passe à bas niveau. L'impulsion F est mise en forme par la bascule monostabile 8 et le signal de gâchette Q1 est fourni, éventuellement par l'intermédiaire d'un amplificateur, à la gâchette G du triac 4 pendant une durée TI. La sortie Q1* du circuit monostable 8 est transmise au circuit monostable 9 qui se déclenche sur le front montant de ce signal (correspondant au front descendant du signal Q1). Cette bascule monostable 9 fournit alors pendant une durée T2 un signal de validation à la porte ET 10. Si, pendant cette durée, il ne se produit aucun changement d'état du signal W, les signaux Q1 et Q2 restent tous deux à bas niveau jusqu'à l'instant t2 de l'alternance suivante de la tension du secteur. L'un des rôles essentiels de l'inhibition par le signal Q2 de la porte ET 10 est d'empêcher que la montée du signal W se produisant à l'instant t0 ne provoque un changement d'état du signal Q1, ce qui serait le cas si le signal W était directement appliqué à la porte OU 7 sans l'opération de validation apportée par la porte ET 10.

Si l'on suppose, comme cela est indiqué en figure 2, que l'amorçage du triac ne se produit pas de façon convenable et, qu'après la chute de l'impulsion de gâchette fournie par le signal Q1, le triac se désamorce dès que la tension à ses bornes croît pour dépasser à nouveau la tension $V_S$ au cours de l'intervalle de temps T2, il se produit à l'instant t3 une remontée du signal W et, par conséquent, une remontée du signal Q1. Dans les figures, on a supposé que le processus doit être répété trois fois aux instants t3, t4 et t5 et que c'est seulement après la quatrième impulsion de gâchette que le triac est effectivement amorcé. Une explication de cette nécessité de produire des impulsions multiples dans certains cas particuliers peut se voir en relation avec la courbe indiquant les variations du courant I dans le triac. Si, après la première impulsion de gâchette, le courant I n'a pas atteint une valeur $I_L$ habituellement désignée par l'expression »courant de maintien«, le triac ne s'amorce pas. Il convient que l'impulsion de gâchette suivante soit appliquée très rapidement pour que le courant n'ait pas le temps de décroître de façon notable avant l'application de l'impulsion de gâchette suivante. Ainsi, au cours de chaque impulsion de gâchette successive, la valeur du courant dans le triac croît. C'est là l'une des raisons pour lesquelles il convenait de choisir, comme on l'a indiqué précédemment, une valeur de la tension Vs de seuil de détection aussi faible que possible. A titre d'ordre de grandeur, cette tension Vs sera choisie de l'ordre de la dizaine de volts et les durées T1 et T2 des impulsions Q1 et Q2 pourront être de même valeur, par exemple 20 microsecondes. Bien entendu, cette valeur dépend essentiellement de la nature du circuit le plus selfique sur lequel est susceptible d'être branché le dispositif de déclenchement selon l'invention.

Une variante du circuit selon l'invention est illustrée en figure 3. Dans cette variante, le premier circuit monostable 8 est supprimé et les impulsions de sortie de la porte OU 7 sont directement appliquées à la gâchette du triac (éventuellement par l'intermédiaire d'un circuit amplificateur). La deuxième bascule monostable 9 déclenchable sur le front montant ou sur le front descendant des impulsions de sortie de la porte OU 7 permet la validation de la porte ET 10 seulement pendant un bref intervalle de temps après chaque impulsion de gâchette. Dans ce mode de réalisation, on joue sur la durée inhérente de l'impulsion minimale fournie à la sortie de la porte OU et liée au temps de propagation de l'information à travers le détecteur de seuil, la porte ET, la porte OU et le triac.

Le circuit selon la présente invention est susceptible d'autres variantes de réalisation du moment que l'on conserve les deux caractéristiques principales, à savoir que le signal d'un détecteur de seuil est transmis à la gâchette d'un triac, d'une part, un certain temps après chaque passage à zéro par l'intermédiaire d'un modulateur, d'autre part, après une première impulsion si, et seulement si, il se produit un désamorçage au cours d'une durée déterminée après chaque impulsion.

Dans la description précédente, les divers blocs désignés comme détecteurs de seuil et comme modulateurs n'ont pas été représentés sous forme de circuits détaillés étant donné que la réalisation de tels circuits est à la protée de l'homme de l'art à partir du moment où la fonction de ces circuits a été définie, ce qui a été fait précédemment. On notera que l'un des aspects importants de la présente invention est que les circuits décrits se prêtent tout particulièrement à une réalisation sous forme de circuits intégrés. Notamment, le modulateur pourra être de type numérique et non analogique.

La présente invention n'est pas limitée aux modes de réalisation qui ont été explicitement décrits, elle en contient au contraire les diverses variantes et généralisations incluses dans le domaine des revendications ci-après.

## Revendications

1. Procédé autoadaptatif d'amorçage' d'un triac (4) en série avec une charge (3) alimentée électriquement, comprenant les étapes consistant à:

— fournir une première impulsion brève de gâchette au triac à un instant choisi,
— détecter le non-amorçage éventuel du triac après l'arrêt de l'impulsion de gâchette,
— fournir une autre impulsion brève de gâchette au triac au cas où la détection indiquerait un non-amorçage,
— répéter ces opérations jusqu'à amorçage,

caractérisé en ce que l'intervalle de temps maximal entre deux impulsions brèves de gâchette, c'est-à-dire la durée pendant laquelle est effectuée la détection d'un éventuel non-amorçage et la possibilité de fournir une autre impulsion brève de gâchette, est suffisamment court pour que le courant dans la charge ne subisse pas de décroissance notable pendant cet intervalle.

2. Dispositif autoadaptatif d'amorçage d'un triac (4) en série avec une charge électrique, comprenant un circuit (5) pour détecter que la tension aux bornes du triac a dépassé un seuil déterminé et fournissant un signal (W) à haut niveau quand et tant que ce seuil est dépassé, et un circuit modulateur réglable (6) recevant le signal en provenance du détecteur et fournissant une première impulsion de commande de gâchette (F) de durée brève au bout d'un temps réglé après que le signal du détecteur est passé de niveau bas à niveau haut, caractérisé en ce que le circuit modulateur est réalisé de façon à ne fournir d'impulsions que si son signal d'entrée reste à niveau haut pendant toute la durée du temps réglé, et en ce que le dispositif comprend en outre des moyens pour fournir d'autres impulsions brèves de gâchette au triac si le signal du détecteur repasse de niveau bas à niveau haut au cours d'un intervalle de temps qui suit l'application de chaque impulsion brève, cet intervalle de temps ayant une durée suffisamment courte pour que le courant dans la charge ne subisse pas de décroissance notable au cours de son écoulement.

3. Dispositif selon la revendication 2 caractérisé en ce qu'il comprend:

— une porte ET (10) à deux entrées recevant à sa première entrée le signal (W) de sortie du détecteur de seuil (5),
— une porte OU (7), recevant la sortie de la porte ET (10) et la sortie du modulateur (5), et dont la sortie est reliée à la gâchette (G) du triac (4),
— un circuit monostable (9) recevant la sortie de la porte OU et alimentant la deuxième entrée de la porte ET.

4. Dispositif selon la revendication 3 caractérisé en ce qu'il comprend en outre un deuxième circuit monostable (8) connecté entre la sortie de la porte OU (7) et l'entrée du premier circuit monostable (9), sa sortie normale étant reliée à la gâchette du triac et sa sortie complémentaire à l'entrée de la deuxième bascule monostable, les deux bascules monostables étant déclenchées par l'apparition de fronts montants.

**Patentansprüche**

1. Selbstanpassendes Verfahren zum Zünden eines Triac (4), der in Reihe mit einer elektrisch gespeisten Last (3) liegt, welches folgende Schritte umfaßt:

- Anlegen eines ersten kurzen Auslöseimpulses an den Triac zu einem gewählten Zeitpunkt,
- Feststellung der eventuellen Fehlzündung des Triac nach Beendigung des Auslöseimpulses,
- Anlegen eines weiteren Auslöseimpulses an den Triac, wenn eine Fehlzündung festgestellt wird,
- Wiederholung dieser Vorgänge bis zur Zündung,

dadurch gekennzeichnet, daß das maximale Zeitintervall zwischen zwei kurzen Auslöseimpulsen, das heißt die Dauer, während welcher die Feststellung einer eventuellen Fehlzündung erfolgt und die Möglichkeit des Anlegens eines weiteren kurzen Auslöseimpulses besteht, ausreichend kurz ist, damit der in der Last fließende Strom während dieses Intervalls nicht merklich absinkt.

2. Selbstanpassende Vorrichtung zur Zündung eines Triac (4), der in Reihe mit einer elektrischen Last liegt, mit einer Schaltung (5) zur Feststellung, daß die Spannung an den Anschlüssen des Triac einen bestimmten Schwellwert überschritten hat, welche ein Signal (W) mit hohem Pegel dann und so lange liefert, wie dieser Schwellwert überschritten wird, und mit einer einstellbaren Modulierschaltung (6), die das Signal aus dem Detektor empfängt und einen ersten Ansteuerimpuls (F) kurzer Dauer am Ende einer eingestellten Zeitspanne, nachdem das Signal des Detektors von niedrigem Pegel auf hohen Pegel übergegangen ist, abgibt, dadurch gekennzeichnet, daß die Modulierschaltung derart ausgebildet ist, daß sie nur dann Impulse abgibt, wenn ihr Eingangssignal während der gesamten Dauer der eingestellten Zeit auf hohem Pegel bleibt, und daß die Vorrichtung ferner Mittel umfaßt, um weitere kurze Auslöseimpulse für den Triac zu liefern, wenn das Detektorsignal wieder von niedrigem Pegel auf hohen Pegel im Verlaufe eines Zeitintervalls geht, welches auf die Anlegung jedes kurzen Impulses folgt, wobei dieses Zeitintervall eine ausreichend kurze Dauer aufweist, damit der Strom in der Last während seines Ablaufs nicht merklich absinkt.

3. Vorrichtung nach Anspruch 2, dadurch gekennzeichnet, daß sie umfaßt:

- eine AND-Schaltung (10) mit zwei Eingängen, von denen der erste das Signal (W) vom Ausgang des Schwellwertdetektors (5) empfängt,
- eine OR-Schaltung (7), welche das Ausgangssignal der AND-Schaltung (10) und das Ausgangssignal des Modulators (5) empfängt, während ihr Ausgang mit der Steuerelektrode (G) des Triac (4) verbunden ist,
- eine monostabile Schaltung (9), die das Ausgangssignal der OR-Schaltung empfängt und den zweiten Eingang der AND-Schaltung speist.

4. Vorrichtung nach Anspruch 3, dadurch gekennzeichnet, daß sie ferner eine zweite monostabile Schaltung (8) umfaßt, die zwischen den Ausgang der OR-Schaltung (7) und den Eingang der ersten monostabilen Schaltung (9) geschaltet ist, wobei ihr normaler Ausgang mit der Steuerelektrode des Triac und ihr komplementärer Ausgang mit dem Eingang der zweiten monostabilen Kippschaltung verbunden ist, wobei die zwei monostabilen Kippschaltungen durch die Anstiegsflanken gesteuert sind.

**Claims**

1. Self-adapting method of triggering a triac (4) connected in series with an electrically supplied load (3), comprising the steps consisting in:

- supplying a first short trigger pulse to the triac at a selected moment,
- detection of an eventual failure of ignition of the triac at the end of the trigger pulse,
- supplying a further short trigger pulse to the triac in case the detection would indicate failure of ignition,
- repeating these operations until ignition has occurred,

characterized in that the maximum time interval between two short trigger pulses, i.e. the time during which an eventual failure of ignition is detected and it is possible to supply a further short trigger pulse, is sufficiently short so that the current flowing through the load will not noticeably decrease during this inverval.

2. Self-adapting device for triggering a triac (4) connected in series with an electrical load, comprising a circuit (5) for detecting when the voltage at the terminals of the triac has exceeded a determined threshold and supplying a high level signal (W) when and as long as this threshold is exceeded, and an adjustable modulator circuit (6) receiving the signal from the detector and supplying a first gate control pulse (F) of a short duration at the end of an adjusted time after the detector signal has passed from low level to high level, characterized in that the modulator circuit is embodied in such a manner that it supplies pulses only if its input signal remains on high level during the entire duration of the adjusted time, and in that the device further comprises means for supplying further short trigger pulses to the triac if the detector signal passes anew from the low level to the high level in the course of a time interval following the application of each short pulse, this time interval having a sufficiently short duration so that the current flowing through the load will not noticeably decrease in the course of its duration.

3. Device according to claim 2, characterized in that it comprises:

— an AND gate (10) having two inputs the first of which receives the output signal (W) of the threshold detector (5),
— an OR gate (7) receiving the output of the AND gate (10) and the output of the modulator (5), and the output of which is connected to the gate (G) of the triac(4),
— a monostable circuit (9) receiving the output of the OR gate and feeding the second input of the AND gate.

4. Device according to claim 3, characterized in that it further comprises a second monostable circuit (8) connected between the output of the OR gate (7) and the input of the first monostable circuit (9), the normal output being connected to the gate of the triac and its complementary output to the input of the second monostable circuit, the two monostable circuits being triggered upon appearance of the rising edges.

Fig. 1

Fig. 3

Fig.2